# EUROPEAN PATENT APPLICATION

(11) **EP 0 917 183 A2**
(43) Date of publication of application: **19.05.1999**
(21) Application number: 98203782.2
(22) Date of filing: 10.11.1998
(51) Int. Cl.: H01L 21/00

(54) **Clean box**

(30) Priority: 11.11.1997 JP 325486/97
(71) Applicant: Innotech Corporation, Yokohama-shi, Kanagawa-ken 222-8580 (JP)
(72) Inventor: Yoshida, Minoru, Yokohama-shi, Kanagawa-ken 222-8580 (JP)
(74) Representative: Van kan, Johan Joseph Hubert, Ir.

(57) **Abstract**

A clean box capable of being effectively applied to a room reduced in cleanliness as well. The clean box includes a box body made of synthetic resin and a sealedly closable cover made of synthetic resin. The clean box is subject on an outer surface thereof to an antistatic treatment.

## Description

### BACKGROUND OF THE INVENTION

This invention relates to a clean box, and more particularly to a clean box suitable for carrying a wafer substrate while receiving it therein during manufacturing of a semiconductor device.

Conventionally, a clean box of the closed type is made of a synthetic resin material so as to exhibit increased strength, satisfactory sealing properties and the like. The clean box is an exclusive equipment and is sealedly closed after cleanliness at an increased level is formed in the clean box.

Such a clean box is used to carry a wafer substrate to any desired station while receiving it therein during manufacturing of a semiconductor device.

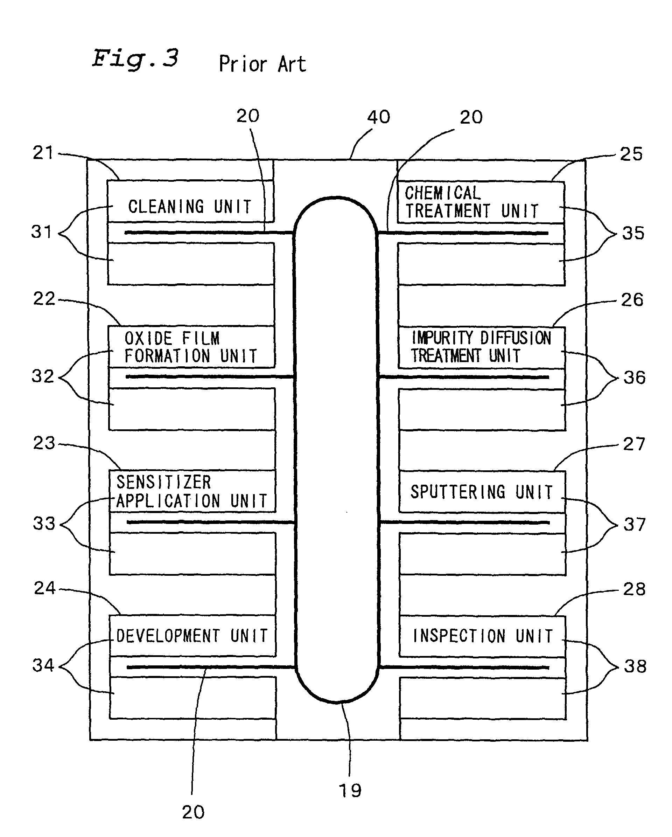

Now, an apparatus for manufacturing a semiconductor device using such a conventional clean box will be described with reference to Fig. 3.

The semiconductor device manufacturing apparatus is generally called a bay system and constituted by a plurality of step bays designated at reference numerals 21 to 28. More specifically, the steps bays include a cleaning step bay 21, an oxide film formation step bay 22, a sensitizer application step bay 23, a development step bay 24, a chemical treatment step bay 25, an impurity diffusion step bay 26, a sputtering step bay 27 and an inspection step bay 28.

Now, the step bays 21 to 28 will be described with reference to Fig. 3.

The cleaning step bay 21 is provided therein with cleaning units 31 each adapted to clean a surface of a wafer substrate.

The oxide film formation step bay 22 is provided therein with oxide film formation units 32 each constructed so as to form a protective film on the surface of the wafer substrate.

The sensitizer application step bay 23 is provided therein with sensitizer application units 33 for applying a sensitizer to the surface of each of the wafer substrates. A development step bay 24 is provided therein with development units 34. The sensitizer application step bay 23 and development step bay 24 cooperate with each other to subject the wafer substrates to photographic processing.

The chemical treatment step bay 25 has chemical treatment units 35 arranged therein, each of which is adapted to subject the wafer substrate to a treatment using chemicals.

The impurity diffusion step bay 26 has impurity diffusion treatment units 36 arranged therein.

The sputtering step bay 27 is provided therein with sputtering units 37 each adapted to form a thin film on each of the wafer substrates.

The inspection step bay 28 is provided therein with inspection units 38 constructed so as to check operation of each of the wafer substrates.

As will be noted from the foregoing, the step bays 21 to 28 each include a plurality of identical treatment units. The wafer substrates are treated by the treatment units of each of the step bays, resulting in semiconductor devices being manufactured.

The conventional semiconductor device manufacturing apparatus also includes a monorail 19 arranged so as to connect the bay steps 21 to 28 to each other in order. The clean box is transferred on the monorail 19 to carry the wafer substrates to the step bays 21 to 28 in order.

Also, the step bays 21 to 28 each have a path 20 arranged therein, which is connected to the monorail 19. The paths 20 each have an automatic carrier arranged thereon so as to be exclusively used for each of the step bays. The automatic carrier acts to unload the clean box from the monorail 19 and carry it to each of the treatment units in each of the step bays 21 to 28.

The treatment units each include a mechanism for setting the wafer substrate at a treatment section of the treatment unit. The setting mechanism functions to introduce the clean box into the treatment unit and then take out the wafer substrate from the clean box in the treatment unit. After the wafer substrate is subject to the predetermined treatment in each of the treatment units, the mechanism returns the wafer substrate to the clean box and then returns the clean box to the automatic carrier outside the treatment unit.

A plurality of treatment steps set in each of the step bays are combined together to constitute manufacturing of the semiconductor device.

The number and order of treatment steps required for manufacturing a semiconductor device are varied depending on a type of the semiconductor device to be manufactured. Thus, the conventional semiconductor device manufacturing apparatus is so constructed that a CPU for control selects a carrier path depending on the type to carry the clean box to the treatment units. The clean box is transferred on the monorail 19 and each of the paths 20 to carry a wafer substrate to the treatment unit intended.

The conventional clean box is typically made of a synthetic resin material, resulting in static electricity readily occurring on a surface of the clean box due to friction. Thus, transferring of the clean box to various treatment units through the paths for the purpose of carrying the wafer substrates thereto causes static electricity to be generated on the surface of the clean box due to friction between the surface and an ambient atmosphere.

This, when any foreign matter such as dust or the like is present in the path, causes it to be collected on the surface of the clean box by static electricity thus generated.

In manufacturing of a transistor which is one of semiconductor devices, it is required to place a wafer substrate in an atmosphere highly increased in cleanliness. This is for the reason that the wafer substrate must be subject to high precision processing. Thus, it is of course that the clean box in which the wafer substrate is received and the treatment units are required to be kept at high cleanliness.

Also, arrangement of the wafer substrate in each of the treatment units requires to clean an outer surface of the clean box, because the clean box is necessarily introduced into each of the treatment units. When any foreign matter such as dust or the like is adhered to the outer surface of the clean box, introduction of the clean box into the treatment unit causes the foreign matter to intrude into the treatment unit. This fails in manufacturing of a semiconductor device with satisfactory quality. Thus, it is not permitted that the clean box having dust collected on the outer surface thereof due to friction between the outer surface and an ambient atmosphere by movement thereof is introduced into the treatment unit.

This requires that the monorail 19 and paths 20 are likewise kept clean.

In order to meet the requirements, the prior art is so constructed that a room 40 in which all of the treatment units and paths are arranged is kept clean as a whole. Unfortunately, this requires that the room is constructed so as to have a space increased to a degree sufficient to permit the treatment units and paths to be received therein. In order to keep such a highly increased space of the room clean, a large scale equipment is required, leading to an increase in equipment cost.

### SUMMARY OF THE INVENTION

The present invention has been made in view of the foregoing disadvantage of the prior art.

Accordingly, it is an object of the present invention to provide a clean box which is capable of being effectively applied to a room reduced in cleanliness as well.

In accordance with the present invention, a clean box is provided. The clean box includes a box body made of synthetic resin and a sealedly closable cover made of synthetic resin. The clean box is subject on an outer surface thereof to an antistatic treatment.

The term "antistatic function" or "antistatic treatment" referred to herein indicates a function or treatment for keeping static electricity from occurring on a surface of synthetic resin. For this purpose, an antistatic material may be kneaded in a resin material for the clean box or coated on an outer surface of the clean box.

Alternatively, if the clan box is made of a resin material which essentially exhibits an antistatic function, use of such an antistatic material may be eliminated.

### BRIEF DESCRIPTION OF THE DRAWINGS

These and other objects and many of the attendant advantages of the present invention will be readily appreciated as the same becomes better understood by reference to the following detailed description when considered in connection with the accompanying drawings; wherein:
Fig. 1 is a schematic sectional view showing an embodiment of a clean box according to the present invention;
Fig. 2 is a fragmentary schematic perspective view showing a semiconductor device manufacturing apparatus in which the clean box shown in Fig. 1 is incorporated; and
Fig. 3 is a block diagram schematically showing a conventional semiconductor device manufacturing apparatus.

### DETAILED DESCRIPTION OF THE PREFERRED EMBODIMENT

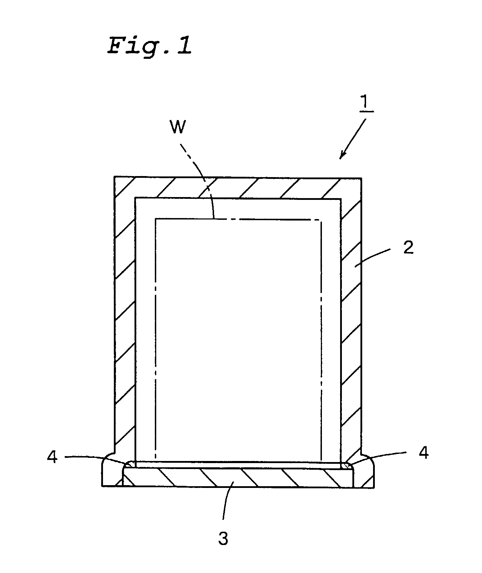

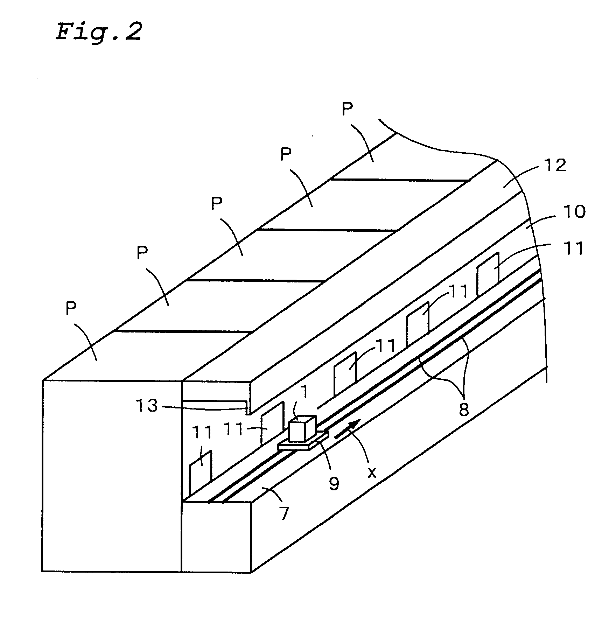

Now, a clean box according to the present invention will be described hereinafter with reference to Figs. 1 and 2.

Referring first to Fig. 1, an embodiment of a clean box according to the present invention is illustrated. A clean box of the illustrated embodiment generally designated at reference numeral 1 generally includes a box body 2 made of synthetic resin and a cover 3 likewise made of synthetic resin. The box body 2 is provided on a lower portion thereof with a seal member 4. The cover 3 is arranged under the seal member 4. The cover 3 is provided thereon with a fixing mechanism (not shown), through which the cover 3 is fixed on the box body 2.

Receiving of a wafer substrate in the clean box 1 thus constructed is carried out by placing a wafer ring rack W having a wafer ring held thereon on the cover 3 and then putting the box body 2 on the cover 3. Then, the cover 3 is fixed to the box body 2 through the fixing mechanism, to provide the clean box 1 sealedly closed.

The clean box 1 is coated on a whole outer surface thereof with an antistatic material consisting of a polymeric material. This keeps static electricity from substantially occurring on the outer surface of the clean box 1 due to friction between the outer surface of the clean box 1 and an ambient atmosphere.

Referring now to Fig. 2, a semiconductor device manufacturing apparatus in which the clean box 1 thus constructed is incorporated for carrying wafer substrates is illustrated.

In the semiconductor device manufacturing apparatus shown in Fig. 2, the clean box 1 is arranged so as to be moved on a carrier path 7. The carrier path 7 is provided thereon with rails 8, on which a support 9 is transferred. The support 9 is supportedly mounted thereon with the clean box 1 in which wafer substrates are received. The clean box 1 is cleaned at an interior thereof by means of a cleaning equipment (not shown) and then sealedly closed. It is of course that the clean box is kept from having any foreign matter such as dust or the like adhered onto the outer surface thereof.

The carrier path 7 is provided on one side thereof with a wall plate 10 in a manner to upwardly extend therefrom. The carrier path 7 has a plurality of step boxes P arranged on a side of the wall plate 10. The step boxes P each are provided therein with treatment units of the same kinds as those arranged in the step bays 21 to 28 in the prior art described above, which are arranged in order of steps in manufacturing of a semiconductor device. The treatment units are arranged in the lump. The wall plate 10 is formed with access ports 11 in correspondence to the step boxes P.

The wall plate 10 is provided on an upper portion thereof with a clean bench 12 in a manner to be positioned above the carrier path 7. The clean bench 12 functions to jet clean air toward the carrier path 7. The clean air thus jetted acts to render a space between the clean bench 12 and the carrier path 7 clean. The wall plate 10 functions to prevent the clean air from flowing out from a side of the manufacturing apparatus on which the wall plate 10 is arranged.

The clean bench 12 is provided at an edge thereof on a side thereof opposite to the wall plate 10 with an air guide 13 in a manner to downwardly extend therefrom, so that satisfactory downward flowing of the clean air may be ensured. Flowing of the clean air along the air guide 13 functions as an air curtain which prevents an external or ambient atmosphere from entering the clean space above the carrier path 7 and keeps the clean air in the clean space from flowing out to the ambient atmosphere.

The clean box 1 is moved on the carrier path 7 in a direction indicated at an arrow X in Fig. 2, to thereby carry the wafer substrates to each of the step boxes. The clean box 1, as described above, is coated on the outer surface thereof with the antistatic material, so that movement of the clean box on the carrier path 7 does not cause static electricity due to the friction to occur on the outer surface of the clean box 1. In the illustrated embodiment, the clean bench 12 keeps the space above the carrier path 7 clean. Coating of the antistatic material on the outer surface of the clean box 1 effectively prevents a foreign matter such as dust or the like from adhering to the outer surface of the clean box 1 due to static electricity by the friction even when cleanliness in the space is reduced.

The clean box 1 thus constructed is introduced through each of the access ports 11 of the wall plate 10 to the each of the step boxes P corresponding thereto.

The step boxes P each are provided therein with a wafer substrate carrier mechanism (not shown). The wafer substrate carrier mechanism functions to carry the clean box 1 introduced through the access port 11 into the step box P to each of the treatment units in the step box P. The treatment units each include a setting mechanism for setting each of the wafer substrates received in the clean box 1 in a treatment section of each of the treatment units without exposing it to an ambient atmosphere, as in the prior art. The setting mechanism functions to take out each of the wafer substrates from the clean box to subject it to each of the treatments intended. At this time, the outer surface of the clean box 1 is kept clean, to thereby keep any foreign matter such as dust or the like from entering each of the step boxes P and each of the treatment units.

Thus, the clean box 1 moved on the carrier path 7 keeps any foreign matter such as dust or the like from adhering to the outer surface thereof due to static electricity. This eliminates a necessity of keeping the space above the carrier path 7 at cleanliness at an increased level. Thus, the illustrated embodiment does not require the above-described large scale equipment for keeping the whole room 4 used in the prior art shown in Fig. 3 in which all of the treatment units and the carrier path are arranged at increased cleanliness.

Also, in the illustrated embodiment, the clean bench 12 is arranged so as to extend along the carrier path 7. Alternatively, the illustrated embodiment may eliminate arrangement of the clean bench 12. Nevertheless, arrangement of the clean bench 12 permits the clean box 1 to be kept cleaner. However, the illustrated embodiment does not require to excessively increase cleanliness irrespective of arrangement of the clean box 12.

The illustrated embodiment which permits cleanliness in the space above the carrier path 7 to be thus reduced leads to simplification in a clean air generating mechanism of the clean bench, resulting in an equipment cost being further decreased.

Further, the clean box 1 of the illustrated embodiment eliminates arrangement of the semiconductor device manufacturing apparatus of the bay system in the clean room 40 as shown in Fig. 3, because the clean box 1 keeps any foreign matter such as dust or the like from adhering to the outer surface thereof even when it is moved in an ambient atmosphere.

In the illustrated embodiment, the clean box 1 is coated on the outer surface with an antistatic material. Alternatively, it may be made of a resin material hard to charge. The resin hard to charge may be used for either the whole clean box or only the outer surface of the clean box.

As can be seen from the foregoing, the present invention substantially keeps any foreign matter such as dust or the like from adhering to the outer surface of the clean box. This eliminates a necessity of keeping the carrier path for the clean box at increased cleanliness when the clean box is applied to a semiconductor device manufacturing apparatus. Thus, the present invention not only eliminates arrangement of such a clean room in which all of treatment units and a carrier path are arranged as in the prior art, but does not need to keep the space above the carrier path at increased cleanliness, resulting in substantially reducing an equipment cost.

While a preferred embodiment of the invention has been described with a certain degree of particularity with reference to the drawings, obvious modifications and variations are possible in light of the above teachings. It is therefore to be understood that within the scope of the appended claims, the invention may be practiced otherwise than as specifically described.

## Claims

1. A clean box comprising a box body made of synthetic resin and a sealedly closable cover made of synthetic resin, and provided with an antistatic function.

2. The clean box according to claim 1, characterized in that, the clean box has a ze to carry one or more wafer substrates for manufacturing a semiconductor device.

3. The clean box according to claims 1-2, characterized in that the outer surface of the box comprises the antistatic function.

4. The clean box according to claim 3, characterized in that the synthetic resin for the clean box exhibits an antistatic function.

5. Apparatus for manufacturing the semiconductor which apparatus comprises the clean box according to claims 1-4.
